# EUROPEAN PATENT SPECIFICATION

(11) **EP 2 643 852 B1**
(45) Date of publication and mention of the grant of the patent: **18.07.2018**
(21) Application number: 11785425.7
(22) Date of filing: 22.11.2011
(51) Int. Cl.: H01L 25/075, H01L 33/50

(54) **LED MODULE WITH COMMON COLOR CONVERSION MATERIAL FOR AT LEAST THREE LED CHIPS**
LED-MODUL MIT GEMEINSAMEM FARBUMWANDLUNGSMATERIAL FÜR ZUMINDEST DREI LED-CHIPS
MODULE DE DEL AVEC MATÉRIAU DE CONVERSION DE COULEUR COMMUNE POUR AU MOINS TROIS PUCES DE DEL

(30) Priority: 23.11.2010 DE 102010061801
(43) Date of publication of application: 02.10.2013
(73) Proprietor: Tridonic Jennersdorf GmbH, 8380 Jennersdorf (AT)
(72) Inventor: BAKK, Istvan, 2045 Törökbalint (HU)
(74) Representative: Rupp, Christian
(86) International application number: PCT/EP2011/070636
(87) International publication number: WO 2012/069450

(56) References cited:
- EP-A1- 2 599 120
- WO-A2-2004/032249
- DE-A1-102009 018 088
- US-A- 3 875 456
- US-A1- 2004 217 364
- US-A1- 2007 228 390
- US-A1- 2009 050 911
- US-A1- 2009 212 305
- US-A1- 2010 090 231
- US-A1- 2010 155 766
- US-A1- 2010 201 248

## Description

The present application relates generally to LEDs (light emitting diodes), and more particularly to LEDs having a color conversion material arranged on it.

For obtaining a light that mixes several emission spectra, it is known to provide an arrangement with LEDs of different types, i.e. of different colors. Multi-color-channel LED light can consist of LED modules including e.g. red, green, and blue LED chips to produce e.g. an overall white light by mixing the light emissions of the chips. The light mixing is achieved in that an optical mixing element is applied on top of the LED chips. The result is that the different non-homogenous light emissions are mixed to a homogenous light output.

Nevertheless such an optical mixing element has the drawback that it decreases the light intensity or light output of each channel. This also means that the intensity of the mixed homogenous light output is reduced because of the application of the optical mixing element.

The publication US 2010/078664 A1 discloses a LED phosphor deposition for use with LEDs. A LED device is thereby composed of LED chips that are mounted onto a flat substrate and encapsulated with a material that can be for example a phosphor. The encapsulation is formed by at first applying a dam material to the substrate around the LED chips. The region defined by the dam material is filled with the encapsulation material.

US 2009/212305 discloses a semiconductor light emitting device for varying the color temperature of the emitted light. The device comprises a substrate with a plurality of LED chips covered by a wavelength conversion layer. The LED chips constitute a first and a second group of LED chips, whereby the first group is covered with a thinner portion of wavelength conversion layer and the second group is covered by a thicker portion of wavelength conversion layer.

In view of the problems caused by the state of the art, it is the object of the present invention to improve the adjustment of the light output of LED modules e.g. adjustment of the colour tone, CCT, chromaticity coordinates of LED modules.

This object is achieved by means of the features of the independent claims. The dependent claims develop further the central idea of the present invention.

According to a first aspect of the invention, a LED module is proposed comprising a substrate for LED chips. The LED module further comprises at least three LED chips mounted directly or indirectly onto the substrate. An encapsulation layer is arranged on the LED chips. The encapsulation layer comprises color conversion material for modifying the emission spectrum of the LED chips. The quantity of color conversion material arranged on a first group of at least one LED chip is lower than the quantity of color conversion material arranged on a second group of at least one LED chip. The LED chips of the second group and/or the LED chips of the first group present different emission spectra, and at least one LED chip of the first group and at least one LED chip of the second group emit in the same wavelength range.

The thickness of the encapsulation layer arranged above the LED chip(s) of the first group can be smaller than the thickness of the encapsulation layer arranged above the LED chip of the second group.

The LED module can comprise a globe-top arranged, i.e. dispensed or mounted, on top of the LED chip of the first group.

The globe-top can be free of color conversion material. It can also comprise a color conversion material that is the same or different to the color conversion material of the encapsulation layer. As such, even if the LED chip of the first group and the LED chip of the second group are identical or similar, a different color conversion could be provided for the two groups of LED chips.

The LED module can comprise a preferably reflective underfill that is applied on the substrate after the LED chips are mounted on the substrate.

The LED module can comprise a submount inserted between the substrate and the LED chip of the first group.

The LED module can comprise a dam on the substrate. The encapsulation layer can be formed by filling up the region delimited by the dam by encapsulation material comprising color conversion material, wherein the inner wall of the dam is preferably reflective.

The contour of the dam may be circular, elliptical, rectangular, polygonal or square.

The LED chip(s) of the first group and/or the LED chip(s) of the second group emit different spectra. Accordingly, the light emitted by the LED module is a mixture of at least three different emission spectra.

At least one LED chip of the first group and at least one LED chip of the second group have an identical or similar emission spectrum.

The LED chips mounted on the substrate can have an identical or similar emission spectrum. The light emitted by the LED module is consequently a mixture of two substantially different emission spectra.

The light emitted by the LED module can be a mixture of at least two different emission spectra.

The LED module can comprise separate current control for driving a LED chip of the first group and for driving a LED chip of the second group. This feature allows separate control of current level for adjustment of light output and light intensity with high accuracy.

According to a further aspect of the invention, a retrofit LED lamp, e.g. a spotlight, downlight, floodlight or a LED bulb, comprising the above-mentioned LED module is proposed .

According to a further aspect of the invention, a method is proposed for adjusting the chromaticity coordinate(s) or the spectrum of the light emitted by a LED module. The LED module comprises a substrate for LED chips. It comprises further at least three LED chips mounted directly or indirectly on the substrate. Further it is provided an encapsulation layer comprising color conversion material for converting the emission spectrum of the LED chips into a longer wavelength range. The method comprises arranging the encapsulation layer on the LED chips. The quantity of color conversion material arranged on a first group of at least one LED chip is lower than the quantity of color conversion material arranged on a second group of at least one LED chip. The LED chips of the second group and/or the LED chips of the first group present different emission spectra, and at least one LED chip of the first group and at least one LED chip of the second group emit in the same wavelength range.

Further advantages, features and objects of the present invention will now become evident for the skilled person by reading the following detailed description of the embodiments of the invention, if taken in conjunction with the figures of the enclosed drawings.
Figure 1 shows a LED module according to a first embodiment of the invention,
Figure 2 shows the chromaticity coordinates of the LED module by the CIE 1931 chromaticity diagram according to the first embodiment of the invention,
Figure 3 shows a three dimension model of the LED module according to the first embodiment of the invention,
Figure 4 shows a LED module according to a second embodiment of the invention,
Figure 5 shows a LED module according to a third embodiment of the invention,
Figure 6 shows a CIE 1931 chromaticity diagram with the chromaticity coordinates of the LED module according to the third embodiment of the invention, and
Figure 7 shows a LED module according to a fourth embodiment of the invention.

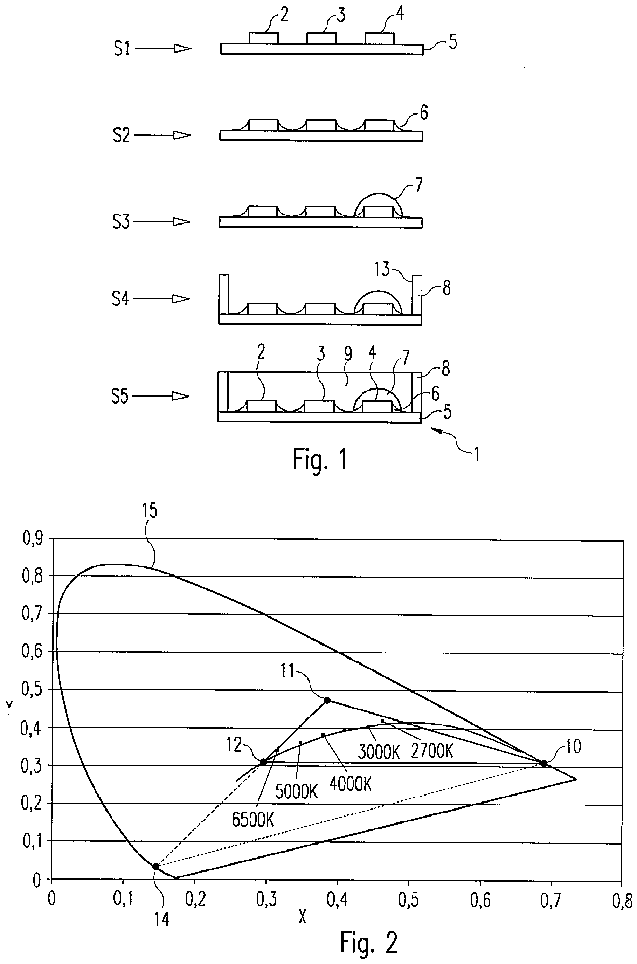

Fig. 1 illustrates a LED (light emitting diode) module 1 according to a first embodiment of the invention. The LED module 1 comprises a plurality of LED chips or dies 2, 3, 4. In the particular embodiment of Fig. 1 three LED chips 2, 3, 4 are provided. One of the LED chips is a red LED 2, i.e. it emits in the red spectrum range or predominantly in the red spectrum range of the visible light (dominant wavelength longer than 600nm). The two others are a first blue LED 3 and a second blue LED 4, i.e. emitting in the blue spectrum range or predominantly in the blue spectrum range (dominant wavelength ca. 420-480nm). Preferably, the first and the second LED chips 3, 4 show an identical or similar emission spectrum.

The LED chips 2, 3, 4 are mounted on a substrate 5. The LED chips 2, 3, 4 are mechanically attached and electrically connected to the substrate 5. The substrate 5 can be formed as a printed circuit board (PCB), e.g. a metal core printed circuit board (MCPCB), or as a surface mount device (SMD) carrier. The substrate 5 could include a LED drive circuitry (not shown). Alternatively, the LED drive circuitry could be separated from the substrate 5 for preventing external heat influencing the characteristic behavior of the LED(s).

An underfill 6 is provided on the substrate 5 in the area where the LED chips 2, 3, 4 are positioned. The underfill 6 can be transparent, which does not affect the light emission of the module 1. It may also be a highly reflective (white) underfill 6 to improve the light output of the LED module. The underfill 6 is optional and preferably does not influence the color tone, chromaticity coordinates of the light emitted by the LED module 1.

On at least the second blue chip 4 a globe-top 7 is dispensed. The globe-top 7 can be transparent, i.e. it does not comprise color conversion particles. However, the globe-top 7, as well as any other transparent material of the LED module, could comprise scattering particles to homogenize the emitted light.

An encapsulation layer 9 is provided above the LED chips 2, 3, 4. Preferably all the LED chips are covered with a common encapsulation layer 9. The encapsulation layer 9 consists of a color conversion layer and comprises color conversion material e.g. a phosphor(s) embedded into a polymer matrix. Applicable polymers are generally epoxy-, silicone resins and their mixtures. As color conversion materials could be all known LED phosphors applied (garnets (e.g. YAG), orthosilicates (e.g. BOSE), nitrides etc.). A dam can be applied surrounding the LED chips to delimit the contour of the encapsulation layer 9 (when seen from above).

The encapsulation layer may be arranged on the LED chips by means of dispensing, direct deposition, mounting or bonding.

The contour of the dam may be circular, elliptical, rectangular, polygonal or square.

According to the embodiments of the invention, the encapsulation layer 9 contains color conversion particles, while the globe-top 7 does not comprise any color conversion particles. Alternatively the globe-top 7 may comprise color conversion particles which are different to those of the encapsulation layer 9.

The LED module 1 is manufactured according to the method illustrated by Fig. 1. In the first step, the LED chips 2, 3, 4 are placed or mounted (S1) onto the substrate 5. Then the transparent underfill 6 is applied onto the substrate 5 (S2). In the following step, the globe-top 7 is mounted, i.e. dispensed or overmoulded, (S3) above the corresponding LED chip 4. In one aspect of this invention a transparent globe-top (not color conversion particles containing) 7 is dispensed at least onto the blue chip(s).

The encapsulation layer 9 is prepared by providing firstly (S4) the dam 8 around the LED chips 2, 3, 4. Further an encapsulation material is applied within the area delimited by the dam 8, i.e. the volume inside the dam 8 is filled with a color conversion particle containing matrix which is covering over all the LED chips 2, 3, 4 emitting in the same (or similar) or in the different wavelength range. Generation of the encapsulation layer could be carried out by dispensing, injection processes etc.

The walls of the dam 8 simply serve as walls containing or retaining the phosphor particles comprising the matrix before curing. No chemical linking or interaction between the dam walls and the filling volume is required. Presumably, formation of chemical links on the interface between dam and filling cannot be excluded. The curing of the dam walls and the filling matrix can be carried out simultaneously. As an alternative in the first step the dam walls and thereafter the filling volume could be cured. The dam walls are characterized as retaining walls. Preferably, the dam walls are in a bigger distance from the LED chips 2, 3, 4 than the LED chips 2, 3, 4 are apart from each other. As an alternative, the distance between the LED chips 2, 3, 4 and the dam walls could be the same or even smaller than the one among the LED chips 2, 3, 4. No reflective coating or reflective characteristic of the dam walls is necessary. Alternatively, at least the inner wall of the dam 8 is highly reflective.

The module 1 of Fig. 1 is a three-color-channel module 1. The particular arrangement of the module 1 is illustrated by Fig. 2 which shows the chromaticity coordinates of the LED module 1 according to the CIE 1931 chromaticity diagram. A first point 10 in the chromaticity diagram refers to the light generated by the red chip 2. Within such a diagram, the outer curved boundary defines the spectral locus 15 corresponding to a monochromatic light. The color point defined by he chromaticity coordinates (x, y) of the first red "point" 10 is e.g. located on the spectral locus 15. A second color point 14 is depicted on the diagram by its x and y coordinates illustrates the light generated by the blue chips e.g. 3, 4. The point 14 is located on spectral locus 15 as it represents the monochromatic light generated by the blue chips 3, 4 unaffected by any color conversion materials.

A third point 11 of the diagram falls to yellow region of the chromaticity diagram according to its chromaticity coordinates (x-y) and corresponds to the blue chip 3 of LED module 1 covered by the encapsulation material 9 without a transparent globe-top. A fourth point 12 corresponds to a rather bluish white (or white) color according to its chromaticity coordinates generated by the blue chip 4 of LED module 1 with the transparent globe-top 7 arranged on it. Due to the globe-top 7, less color conversion material is applied onto the second blue chip 4 than onto the first blue chip 3, which results in different emission spectra of the two blue chips 3, 4 and the corresponding x-y points 11, 12 are distinct within the chromaticity diagram. In particular, a thicker color conversion layer above the first blue chip 3 leads, with respect to the second blue LED chip 4, to a color point with higher x and y values of the corresponding point 11 on the CIE 1931 chromaticity diagram by Fig. 2. Due to the application of the globe-top 7, the encapsulation layer 9 above the second blue LED chip 4 is thinner so that a color point with lower x, y values is obtained.

The application of the globe-top 7 has a direct influence on the chromaticity coordinates x, y of the emitted and converted light by the second blue chip 4. The bigger of the globe-top volume or higher its thickness is, the lower chromaticity coordinates x, y values of point 12 could be obtained. Preferably, the color point 12 determined by its chromaticity coordinates x, y in case of the second blue LED chip 4 is located on the line defined by the color points 11 and 14 as its end points.

The adjustment of the mixed emitted light generated by the LED module 1 can be achieved by varying the x, y values of 12 corresponding to the second blue LED 4 covered with the globe-top 7, which can be generated by modifying the height, the diameter or the volume of the globe-top 7.

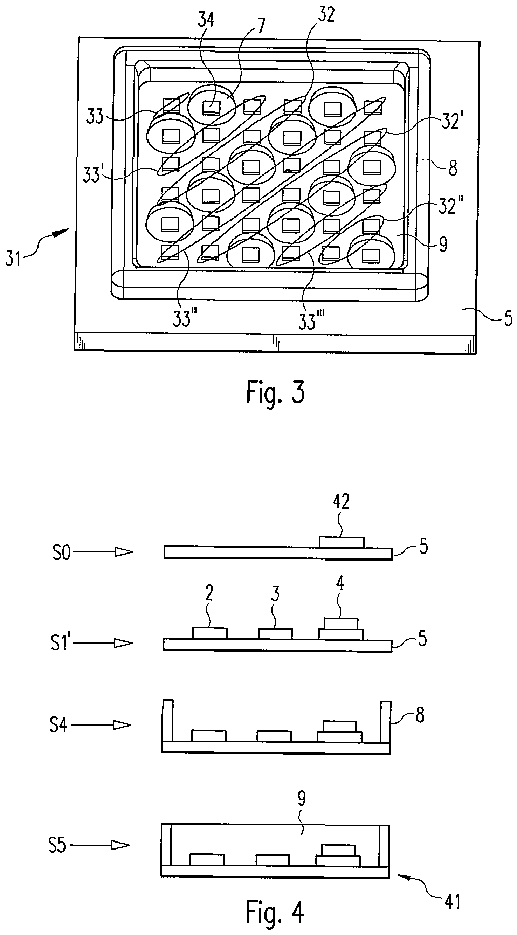

The number of LED chips is not limited to three. Fig. 3 shows an embodiment of a LED module 31 comprising a plurality of LED chips arranged in a matrix-like manner. The LED module 31 comprises approximately the same number of red chips 32, 32', 32", of first blue chips 33, 33', 33", 33''' without globe-top, and of second blue chips 34 with a globe-top 9 arranged above it. The red chips 32, 32', 32" define a first color channel, the first blue chips 33, 33', 33'', 33''' a second color channel, and the second blue chips 34 define a third color channel. Number of LED red, first and second blue chips as well as their ratio to each other could be varied in a wide range according to the invention.

Similarly to the embodiment of Fig. 1, the LED chips are arranged on a substrate 5, a dam 8 surrounding all LED chips is provided and' the encapsulation layer 9 is obtained by a filling method.

Independently of the number of LED chips, color mixing can be improved according to the invention if the LED chips are substantially close to each other. This effect is e.g. achieved in case the distance between two chips is less than 5 times the diameter of a chip. For achieving better color mixing, it is further proposed to keep the distance between two chips lower than 2 times the chip diameter. Particularly, it is proposed to have a distance between two chips lower than the chip diameter. The distance between two chips refers to the distance between two neighboring chips. Alternatively, the distance between two chips can refer to the smallest distance between two chips within the LED module. This distance is also dependent on required thermal properties.

The chips of each color channel are preferably evenly distributed on the substrate 5, as e.g. in the embodiment of Fig. 4. Alternatively, thermal and optical properties can be improved if the chips are distributed in islands (not shown). Each island then advantageously comprises evenly distributed chips, e.g. a given number of chips for each channel, e.g. one chip per channel. In such an embodiment, the distance between two neighboring islands is larger than the distance between two neighboring chips within an island. The color channel islands can form concentric bands.

As shown above with respect to Figs. 1 and 2, the second blue chip 4 has a thinner layer of color conversion material arranged on it than the first blue chip 3 due to the application of the globe-top 7 which is preferably free of color conversion material.

Fig. 4 shows an alternative way of the formation of a thinner color conversion layer (e.g. phosphor layer). According to the embodiment of Fig. 4 the thickness of the encapsulation layer 9 can be modified by providing a submount 42 between the substrate and the second blue LED chip 4. In this embodiment the thickness of the color conversion particle layer over at least the second blue chip 4 can be reduced by mounting at least the second blue chip 4 on the submount 42, such that the second blue LED chip 4 is positioned at a higher level than the at least one of the first blue LED chip 3.

The method of manufacturing a corresponding LED module 41 differs from the one of the LED module 1 with globe-top 7. The present method starts, as shown in Fig. 4, with a submount 42 setting step. Alternatively, an LED chip 4 prefabricated with such a submount 42 could be also applied to avoid long manufacturing process. LED chips applied onto submounts as LED units or SMD LEDs could be taken into account. This step is neglected at the preparation of the LED module according to the embodiment of Fig. 1. In a next step, the red 2 and blue chips 3, 4 are mounted onto (S1') the substrate. This mounting step differs from the corresponding mounting step (S1) of Fig. 1 in that the second blue chip 4 is not directly attached to the substrate 5. Rather, said second blue chip 4 is installed on the submount 42 and is electrically connected to the substrate 5 via said submount 42. Alternatively, direct electrical connection of the blue LED chip 4 to the substrate 5 could be generated by bonding wires (not shown). The application of an underfill 6 at the LED module 1 is optional similar to the method illustrated by Fig.1. The remaining manufacturing steps are similar to ones described in case of Fig. 1. They comprise the following processes providing (S4) the dam 8 around the LED chips 2, 3, 4, and applying encapsulation material within the area delimited by the dam 8 to provide (S5) the encapsulation layer 9 over the LED chips 2, 3, 4.
The adjustment of the emitted mixed light generated by the LED module 41 can be achieved by varying the x-y values of the second blue LED 4, which can be achieved by modifying the thickness (the height) or the volume of the submount 42. The higher the submount 42, the smaller the volume of the color conversion layer above the second blue LED 4.
The LED module 41 fabricated by application of a submount 42 could have the advantage in comparison to the LED module 1 comprising a globe-top 7 that e.g. the manufacturing process could be simpler, cheaper and/or shorter by applying a LED chip 4 with a submount 42. On the other hand, the submount 42 being provided for the second blue chip 4 may also be disadvantageous since thermal properties of the LED module 41, e.g. heat dissipation can be negatively affected depending on the material of the applied submount.

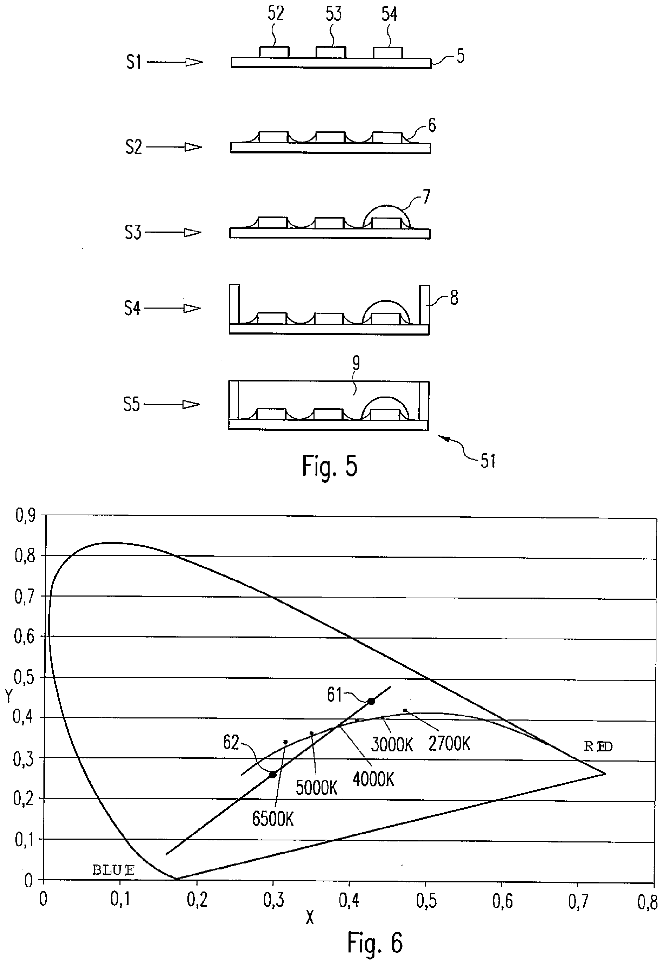

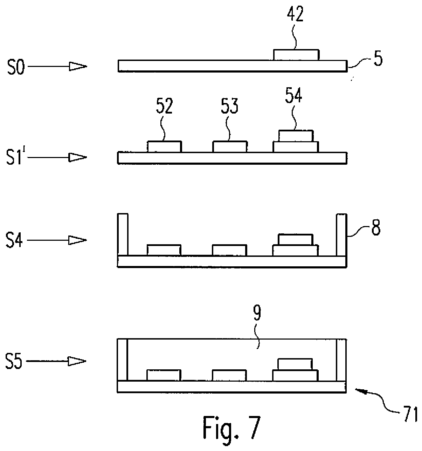

Fig. 5 shows a LED module 51 according to an illustrative example. This LED module 51 comprises three LED chips 52, 53, 54 that are identical or similar providing an at least similar emission spectrum. The LED chips are e.g. blue, the emit light exclusively or mainly in the blue wavelength range of the visible part of the electromagnetic radiation spectrum. Beside this difference all LEDs are similar. The structure of the LED module 51 corresponds to the one of the LED module 1 shown by Fig. 1. A globe-top 7 is placed onto one LED 54, but not onto the other two LEDs 52, 53. This way, a thicker encapsulation layer, i.e. a thicker layer of phosphor, is provided above the two first LEDs 52, 53. A thinner encapsulation layer is provided above the third LED 54.
In the CIE 1931 chromaticity diagram shown in Fig. 6, the color point 61 described by its x and y coordinates corresponds to the light emitted by the two first LEDs 52, 53, while the color point 62 corresponds to the light emitted by the third LED 54 covered with the globe-top 7. The emitted mixed light generated by the LED module 51 can be modified by varying the position of color point 62 on the diagram, i.e. by modifying e.g. the height, diameter or the volume of the globe-top 7 as described in details above.
The LED module 71 shown in Fig. 7 illustrates a modification of the LED module 51 of Fig. 5 in that, similarly to the embodiment described in Fig. 4, a submount 42 is applied below the third LED 54 instead of mounting a globe-top onto it.

As already seen with the embodiment of Fig. 3, the LED module is not restricted to LED modules including exactly three LED chips or even three color channels. At least two LEDs and two color channels are provided, one of the LEDs defining one channel and at least another LED defining the other color channel. The thickness of the encapsulation layer is reduced covering at least the LED of one of the color channels. In the example of Figs. 5 and 7 applying blue chips only, it is preferred that at least two different chips have an individual current control. In the embodiments of Fig. 5 and 7 with two color channels, each channel is preferably controlled separately. In the embodiments of Fig. 1 and 4 applying three color channels, each of the three channels is preferably controlled separately. Thus, variations in the emission spectrum can be compensated by adjusting the current of the different channels separately. In case of the LED module 51 according to Fig. 5, at least the second blue chip 54 with the transparent globe-top 7 dispensed onto it could be adjusted as a function of the at least one blue chip 53 onto which no globe-top is arranged. Therefore, variations due to the production can be compensated by adjusting the current or current ratio between a blue LED chip with globe-top and one blue LED chip without globe-top until the desired color point in the CIE diagram is reached.
The invention thus provides a method for controlling the color point or compensating its variations in order to have a constant color point by the following two options which could be even combined. At first it is possible to vary the volume or the height of the transparent globe-top vs. the thickness or volume of the color conversion layer. The second possibility is to adapt the position level (in height) of the at least one LED chip. An additional option represents the individual current control of the at least two different LED chips, one of the LED chips having a transparent globe-top or a submount while the other one does not own a globe-top or a submount, i.e. the latter one has a thicker color conversion layer above it. This option may be combined with the other two.

### Reference signs

- 1: LED module
- 2: red LED chip
- 3: first blue LED chip
- 4: second blue LED chip
- 5: substrate
- 6: underfill
- 7: globe-top
- 8: dam
- 9: encapsulation
- 10: X-Y representation of the light generated by LED chip 2 of LED module 1
- 11: X-Y representation of the light generated by LED chip 3 of LED module 1
- 12: X-Y representation of the light generated by LED chip 4 of LED module 1
- 13: inner wall of the dam 8
- 14: X-Y representation of the light generated by LED chip 3, 4 alone
- 15: spectral locus of the CIE 1931 chromaticity diagram
- 16, 66: Plankian locus (full radiation locus)
- 41: LED module according to Fig. 4
- 42: submount
- 51: LED module according to Fig. 5
- 52, 53, 54: LED chip
- 61: light generated by LED chip 52, 53 in the CIE 1931 chromaticity diagram
- 62: light generated by LED chip 54 in the CIE 1931 chromaticity diagram
- 71: LED module according to Fig. 7

## Claims

1. A LED module (1) comprising
- a substrate (5) for LED chips,
- at least three LED chips (2, 3, 4) mounted directly or indirectly on the substrate (5), and
- a common encapsulation layer (9) disposed on the LED chips (2, 3, 4) and comprising color conversion material for modifying the emission spectrum of the LED chips (2, 3, 4),
wherein the quantity of color conversion material disposed on a first group of at least one LED chip (4) is lower than the quantity of color conversion material disposed on a second group of at least one LED chip (2, 3), and wherein at least one LED chip (4) of the first group and at least one LED chip (3) of the second group emit in the same wavelength range, **characterized in that** the LEDs chips (2, 3) of the first group and/or the LED chips (4) of the second group present different emission spectra.

2. A LED module (1) according to claim 1,
wherein the thickness of the encapsulation layer (9) above the LED chip (4) of the first group is smaller than the thickness of the encapsulation layer (9) above the LED chip (2, 3) of the second group.

3. A LED module (1) according to any of the preceding claims,
comprising a globe top (7) disposed, i.e. dispensed or mounted, on top of the LED chip (4) of the first group.

4. A LED module (1) according claim 3,
wherein the globe top (7) is free of color conversion material, or comprises a color conversion material that is different to the color conversion material of the encapsulation layer 9.

5. A LED module (1) according to claim 3 or 4,
comprising an underfill (6) that is applied on the substrate (5) after the LED chips (2, 3, 4) are mounted on the substrate (5).

6. A LED module (1) according to any of the preceding claims,
comprising a submount (42) inserted between the substrate (5) and the LED chip (4) of the first group.

7. A LED module (1) according to any of the preceding claims,
comprising a dam (8) on the substrate (5) such that the encapsulation layer (9) can be formed by filling the region delimited by the dam (8) by encapsulation material comprising color conversion material, wherein the inner wall (13) of the dam (8) is preferably reflective.

8. A LED module (1) according to any of the preceding claims,
comprising separate current control for driving a LED chip (4) of the first group and for driving a LED chip (2, 3) of the second group.

9. A lamp, particularly a spotlight, comprising a LED module (1) according to any of the preceding claims.

10. A method for adjusting the chromaticity coordinate or the spectrum of the light emitted by a LED module (1) comprising
- a substrate (5) for LED chips,
- at least three LED chips (2, 3, 4) mounted (S1) directly or indirectly on the substrate (5), and
- a common encapsulation layer (9) comprising color conversion material for shifting the emission spectrum of the LED chips (2, 3, 4),
the method comprising disposing (S5) the encapsulation layer (9) on the LED chips (2, 3, 4),
wherein the quantity of color conversion material disposed on a first group of at least one LED chip (4) is lower than the quantity of color conversion material disposed on a second group of at least one LED chip (2, 3), wherein the LED chips (2, 3) of the second group and/or the LED chips (4) of the first group present different emission spectra, and wherein at least one LED chip (4) of the first group and at least one LED chip (3) of the second group emit in the same wavelength range.

## Patentansprüche

1. LED-Modul (1), umfassend
- ein Substrat (5) für LED-Chips,
- mindestens drei LED-Chips (2, 3, 4), direkt oder indirekt auf das Substrat (5) montiert, und
- eine gemeinsame Einkapselungsschicht (9), die auf den LED-Chips (2, 3, 4) angeordnet ist und Farbumwandlungsmaterial zum Modifizieren des Emissionsspektrums der LED-Chips (2, 3, 4) umfasst,
wobei die Menge an Farbumwandlungsmaterial, die auf einer ersten Gruppe von mindestens einem LED-Chip (4) angeordnet ist, geringer ist als die Menge von Farbumwandlungsmaterial, die auf einer zweiten Gruppe von mindestens einem LED-Chip (2, 3) angeordnet ist, und wobei mindestens ein LED-Chip (4) der ersten Gruppe und mindestens ein LED-Chip (3) der zweiten Gruppe in demselben Wellenlängenbereich emittieren, **dadurch gekennzeichnet, dass** die LED-Chips (2, 3) der ersten Gruppe und/oder die LED-Chips (4) der zweiten Gruppe unterschiedliche Emissionsspektren präsentieren.

2. LED-Modul (1) nach Anspruch 1,
wobei die Dicke der Einkapselungsschicht (9) über dem LED-Chip (4) der ersten Gruppe kleiner ist als die Dicke der Einkapselungsschicht (9) über dem LED-Chip (2, 3) der zweiten Gruppe.

3. LED-Modul (1) nach einem der vorhergehenden Ansprüche,
umfassend ein Kugeloberteil (7), das oben auf dem LED-Chip (4) der ersten Gruppe angeordnet, d. h. verteilt oder montiert, ist.

4. LED-Modul (1) nach Anspruch 3,
wobei das Kugeloberteil (7) frei von Farbumwandlungsmaterial ist oder ein Farbumwandlungsmaterial umfasst, das sich von dem Farbumwandlungsmaterial der Einkapselungsschicht (9) unterscheidet.

5. LED-Modul (1) nach Anspruch 3 oder 4,
umfassend eine Unterfüllung (6), die auf das Substrat (5) aufgebracht wird, nachdem die LED-Chips (2, 3, 4) auf das Substrat (5) montiert wurden.

6. LED-Modul (1) nach einem der vorhergehenden Ansprüche,
umfassend eine Unterhalterung (42), die zwischen dem Substrat (5) und dem LED-Chip (4) der ersten Gruppe eingesetzt ist.

7. LED-Modul (1) nach einem der vorhergehenden Ansprüche,
umfassend einen Damm (8) auf dem Substrat (5), derart, dass die Einkapselungsschicht (9) durch Befüllen der durch den Damm (8) abgegrenzten Region durch Farbumwandlungsmaterial aufweisendes Einkapselungsmaterial ausgebildet werden kann, wobei die Innenwand (13) des Damms (8) bevorzugt reflektierend ist.

8. LED-Modul (1) nach einem der vorhergehenden Ansprüche,
umfassend eine separate Stromsteuerung zum Ansteuern eines LED-Chips (4) der ersten Gruppe und zum Ansteuern eines LED-Chips (2, 3) der zweiten Gruppe.

9. Lampe, insbesondere eine Richtungslampe, umfassend ein LED-Modul (1) nach einem der vorhergehenden Ansprüche.

10. Verfahren zum Einstellen der Farbortskoordinate oder des Spektrums des durch ein LED-Modul (1) emittierten Lichts, umfassend
- ein Substrat (5) für LED-Chips,
- mindestens drei LED-Chips (2, 3, 4), direkt oder indirekt auf das Substrat (5) montiert (S1), und
- eine gemeinsame Einkapselungsschicht (9), umfassend Farbumwandlungsmaterial zum Verschieben des Emissionsspektrums der LED-Chips (2, 3, 4),
wobei das Verfahren Anordnen (S5) der Einkapselungsschicht (9) auf den LED-Chips (2, 3, 4) umfasst,
wobei die Menge an Farbumwandlungsmaterial, die auf einer ersten Gruppe von mindestens einem LED-Chip (4) angeordnet ist, geringer ist als die Menge von Farbumwandlungsmaterial, die auf einer zweiten Gruppe von mindestens einem LED-Chip (2, 3) angeordnet ist, wobei die LED-Chips (2, 3) der zweiten Gruppe und/oder die LED-Chips (4) der ersten Gruppe unterschiedliche Emissionsspektren präsentieren und wobei mindestens ein LED-Chip (4) der ersten Gruppe und mindestens ein LED-Chip (3) der zweiten Gruppe in demselben Wellenlängenbereich emittieren.

## Revendications

1. Module de DEL (1) comprenant
- un substrat (5) pour puces DEL,
- au moins trois puces DEL (2, 3, 4) montées directement ou indirectement sur le substrat (5), et
- une couche d'encapsulation commune (9) disposée sur les puces DEL (2, 3, 4) et comprenant un matériau de conversion de couleur destiné à modifier le spectre d'émission des puces DEL (2, 3, 4),
dans lequel la quantité de matériau de conversion de couleur disposé sur un premier groupe d'au moins une puce DEL (4) est inférieure à la quantité de matériau de conversion de couleur disposé sur un deuxième groupe d'au moins une puce DEL (2, 3), et dans lequel au moins une puce DEL (4) du premier groupe et au moins une puce DEL (3) du deuxième groupe émettent dans la même gamme de longueurs d'onde, **caractérisé en ce que** les puces DEL (2, 3) du premier groupe et/ou les puces DEL (4) du deuxième groupe présentent des spectres d'émission différents.

2. Module de DEL (1) selon la revendication 1,
dans lequel l'épaisseur de la couche d'encapsulation (9) au-dessus de la puce DEL (4) du premier groupe est inférieure à l'épaisseur de la couche d'encapsulation (9) au-dessus de la puce DEL (2, 3) du deuxième groupe.

3. Module de DEL (1) selon l'une quelconque des revendications précédentes,
comprenant un couvercle en forme de globe (7) disposé, c.-à-d. appliqué ou monté, sur le dessus de la puce DEL (4) du premier groupe.

4. Module de DEL (1) selon la revendication 3,
dans lequel le couvercle en forme de globe (7) est dépourvu de matériau de conversion de couleur, ou comprend un matériau de conversion de couleur qui est différent du matériau de conversion de couleur de la couche d'encapsulation (9).

5. Module de DEL (1) selon la revendication 3 ou 4,
comprenant un sous-remplissage (6) qui est appliqué sur le substrat (5) après que les puces DEL (2, 3, 4) ont été montées sur le substrat (5).

6. Module de DEL (1) selon l'une quelconque des revendications précédentes,
comprenant une embase (42) insérée entre le substrat (5) et la puce DEL (4) du premier groupe.

7. Module de DEL (1) selon l'une quelconque des revendications précédentes,
comprenant une barrière (8) sur le substrat (5) de telle sorte que la couche d'encapsulation (9) peut être formée en remplissant la région délimitée par la barrière (8) avec un matériau d'encapsulation comprenant un matériau de conversion de couleur, la paroi interne (13) de la barrière (8) étant de préférence réfléchissante.

8. Module de DEL (1) selon l'une quelconque des revendications précédentes,
comprenant une régulation de courant séparée destinée à commander une puce DEL (4) du premier groupe et à commander une puce DEL (2, 3) du deuxième groupe.

9. Lampe, en particulier un spot, comprenant un module de DEL (1) selon l'une quelconque des revendications précédentes.

10. Procédé de réglage de la coordonnée de chromaticité ou du spectre de la lumière émise par un module de DEL (1) comprenant
- un substrat (5) pour puces DEL,
- au moins trois puces DEL (2, 3, 4) montées (S1) directement ou indirectement sur le substrat (5), et
- une couche d'encapsulation commune (9) comprenant un matériau de conversion de couleur destiné à décaler le spectre d'émission des puces DEL (2, 3, 4),
le procédé comprenant la disposition (S5) de la couche d'encapsulation (9) sur les puces DEL (2, 3, 4),
dans lequel la quantité de matériau de conversion de couleur disposé sur un premier groupe d'au moins une puce DEL (4) est inférieure à la quantité de matériau de conversion de couleur disposé sur un deuxième groupe d'au moins une puce DEL (2, 3), dans lequel les puces DEL (2, 3) du deuxième groupe et/ou les puces DEL (4) du premier groupe présentent des spectres d'émission différents, et dans lequel au moins une puce DEL (4) du premier groupe et au moins une puce DEL (3) du deuxième groupe émettent dans la même gamme de longueurs d'onde.
